# EUROPÄISCHE PATENTANMELDUNG

(11) **EP 4 793 087 A1**
(43) Veröffentlichungstag der Anmeldung: **19.08.2026**
(21) Anmeldenummer: 25157791.2
(22) Anmeldetag: 13.02.2025
(51) Int. Cl.: B60L 53/16, B60L 53/18, B60L 53/302, G01R 1/20, G01R 31/58, B60L 53/51, B60L 53/62, G01R 21/133

(54) **GLEICHSTROM-LADEKABEL**

(71) Anmelder: eLoaded GmbH, 6020 Innsbruck (AT)
(72) Erfinder: Schliernzauer, Thomas, 6020 Innsbruck (AT)
(74) Vertreter: Kimpfbeck, Thomas

(57) **Zusammenfassung**

Es wird en Gleichstrom-Ladekabel (100; 206), insbesondere zum Laden eines Elektrofahrzeugs (104), beschrieben. Das Gleichstrom-Ladekabel (100; 206) umfasst wenigstens eine erste Leitung (106, 108), die dem Elektrofahrzeug (104) Gleichstrom zuführt, wobei die erste Leitung (106, 108) einen Shuntwiderstand zur Ermittlung des Gleichstroms bildet, und einen ersten Temperatursensor (110), der entlang der ersten Leitung (106, 108) angeordnet ist, wobei ein momentaner elektrischer Widerstand des Shuntwiderstands von einer mittels des ersten Temperatursensors (110) ermittelten Temperatur abhängt. Des Weiteren wird ein Messverfahren (300) zur Messung der von einer Ladevorrichtung an ein Elektrofahrzeug abgegebenen elektrischen Energie, sowie eine Verwendung eines Gleichstrom-Ladekabels vorgeschlagen.

## Beschreibung

### GEBIET DER ERFINDUNG

Die vorliegende Erfindung betrifft ein Gleichstrom-Ladekabel, insbesondere zum Laden eines Elektrofahrzeugs, ein Gleichstromladesystem, ein Messverfahren zur Messung der von einer Ladevorrichtung an ein Elektrofahrzeug abgegebenen elektrischen Energie, sowie eine Verwendung eines Gleichstrom-Ladekabels.

### STAND DER TECHNIK

Elektromobilität gewinnt zunehmend an Bedeutung. Ladesäulen gelten als Messgeräte, an deren Messicherheit ein öffentliches Interesse besteht. Gegenwärtig basieren gängige Messsysteme auf eichrechtskonformen Stromzählern, die entweder direkt in die Ladesäule integriert oder als externe Messeinheiten angebracht sind. Diese Messsysteme ermöglichen eine Erfassung der geladenen Energiemenge und dienen als Grundlage für die Abrechnung zwischen Anbieter und Endnutzer.

Konventionelle Messverfahren nutzen meist MID-zertifizierte (Measuring Instruments Directive) Stromzähler, die entweder als direkte Wechselstrom- (AC) oder Gleichstromzähler (DC) arbeiten. Diese sind oft mit Kommunikationsmodulen ausgestattet, um Verbrauchsdaten an Backend-Systeme zu übertragen. Zudem kommen in modernen Ladesystemen Technologien wie Smart Metering, digitale Signaturverfahren zur Datenverifizierung sowie verschlüsselte Übertragungsprotokolle zum Einsatz, um Manipulationen vorzubeugen und eine transparente Abrechnung zu gewährleisten.

Ein Nachteil bestehender Lösungen liegt in den Kosten und dem Wartungsaufwand eichrechtskonformer Messsysteme. Darüber hinaus können nicht alle Messsysteme für alle Anwendungen eingesetzt werden. So können etwa Transformatoren aus der Wechselstromtechnik nicht als Messsystem in der Gleichstromtechnik eingesetzt werden. In der Gleichstrommessung sind Hallsonden und herkömmliche Shuntwiderstände üblich. Herkömmliche Shuntwiderstände sind für kleine Ströme und Spannungen ausgelegt. Strommessungen über 500 A sind mit herkömmlichen Shuntwiderständen technisch schwierig lösbar und/oder sehr teuer.

Aus der DE 102018125598 A1 ist ein Stromzähler zur elektrischen Verbrauchsmessung an einem elektrischen Verbraucher, insbesondere beim Aufladen eines Elektroautos, bekannt. Der bekannte Stromzähler umfasst eine Strommesseinrichtung und eine Spannungsmesseinreichung, die eine Spannung an einem Übergabepunkt eines Ladekabels misst, um Leitungsverluste in dem Ladekabel zu ermitteln, insbesondere zur Berücksichtigung der Leitungsverluste bei der Verbrauchsrechnung.

Aus der DE 102012110527 A1 ein elektrisches Ladesystem bekannt, bei dem eine elektrische Ladeeinrichtung und ein Elektrofahrzeug über ein Ladekabel miteinander verbunden werden. Die elektrische Ladeeinrichtung berechnet einen Spannungsabfallbetrag in dem Ladekabel auf der Basis eines zugeführten Stroms auf der Seite der elektrischen Ladeeinrichtung sowie eines elektrischen Widerstands des Ladekabels. Ferner vergleicht die elektrische Ladeeinrichtung eine Bestimmungsspannung mit einer zugeführten Spannung auf der Seite der elektrischen Ladeeinrichtung und stellt fest, dass eine Batterie auf einen vollständig geladenen Zustand aufgeladen worden ist, wenn die zugeführte Spannung die Bestimmungsspannung erreicht.

Aus der KR 102193414 B1 eine Vorrichtung zur Messung der elektrischen Energie für ein Elektrofahrzeug bekannt, wobei der Verlust eines Ladekabels ermittelt wird und als Verlustleistung subtrahiert wird, um eine genauere Leistungsmessung zu erzielen.

Aus der DE 102019128321 A1 ist ein Verfahren zur Berechnung einer Ladeenergie eines Energiespeichers eines Elektrofahrzeugs bekannt. Bei dem Verfahren wird ein maximaler und ein minimaler Widerstand eines Ladekabels und daraus ein Widerstandsmittelwert des Ladekabels ermittelt, ein Aufladevorgang durchgeführt und eine Ladeenergie unter Verwendung des Widerstandswerts berechnet.

### AUFGABE

Somit besteht die Aufgabe der Erfindung darin ein Gleichstrom-Ladekabel, ein Gleichstromladesystem und ein Messverfahren bereitzustellen, das jeweils kosteneffizient, manipulationssicher und präzise Strom-, Leistungs- und Energiemessungen ermöglicht, ohne die Komplexität unnötig zu erhöhen.

### OFFENBARUNG DER ERFINDUNG

Erfindungsgemäß wird ein Gleichstrom-Ladekabel, insbesondere zum Laden eines Elektrofahrzeugs gemäß Anspruch 1 vorgeschlagen. Das Gleichstrom-Ladekabel umfasst vorzugsweise wenigstens eine erste Leitung, die dem Elektrofahrzeug Gleichstrom zuführt, wobei die erste Leitung einen Shuntwiderstand zur Ermittlung des Gleichstroms bildet, und einen ersten Temperatursensor, der entlang der ersten Leitung angeordnet ist. Ein momentaner elektrischer Widerstand des Shuntwiderstands hängt vorzugsweise von einer mittels des ersten Temperatursensors ermittelten Temperatur ab.

Eine Gleichstromladesäule, im Allgemeinen auch als (DC-Ladesäule bezeichnet, ist im Wesentlichen eine Ladestation für Elektrofahrzeuge, die Gleichstrom direkt in eine Fahrzeugbatterie einspeist. Als elektrische Verbindung zwischen Gleichstromladesäule und Elektrofahrzeug kann das erfindungsgemäße Gleichstrom-Ladekabel dienen. Das erfindungsgemäße Gleichstrom-Ladekabel ermöglicht vorzugsweise schnelles Laden mit hoher Ladeleistungen, insbesondere 50 kW bis 1000 kW. Das Gleichstrom-Ladekabel kann einen Steckverbinder aufweisen, z.B. einen CCS-Steckverbinder (Combined Charging System) oder einen CHAdeMO-Steckverbinder. Die Gleichstromladesäule kann an Autobahnen, Raststätten und Schnellladestationen in Städten angeordnet sein.

Gleichstrom-Ladekabel, im Allgemeinen auch als DC-Ladekabel bezeichnet, dienen vorzugsweise zum schnellen Laden von Elektrofahrzeugen mit Gleichstrom. Das Gleichstrom-Ladekabel kann an der Gleichstromladesäule angeschlagen sein. Ein Nutzer kann so auf ein Mitbringen eines eigenen Ladekabels verzichten. Im Allgemeinen umfasst das Gleichstrom-Ladekabel zwei Hauptstromleiter aus Kupfer für ein Plus- und Minuspol, wobei ein Hauptstromleiter die erste Leitung bilden kann, Pilot- und Kommunikationsleitungen für eine Kommunikation zwischen Elektrofahrzeug und Gleichstromladesäule, Schutzleiter, Schirmung, ein oder mehrere Kühlkanäle mit Kühlfluid, die entlang der zwei Hauptstromleiter angeordnet sind, um die zwei Hauptstromleiter zu kühlen, Isolationsmaterial aus hitzebeständigem Kunststoff oder Silikon und einen Außenmantel aus robustem Gummi oder Thermoplastisches Polyurethan als Schutz vor mechanischen Belastungen, UV-Strahlung und Witterungseinflüssen.

Vorzugsweise führt die erste Leitung Gleichstrom bzw. ist mit Gleichstrom beaufschlagt. Die erste Leitung ist insbesondere ein langgestreckter Leiter, der Kupfer umfasst und der einen Anfang und ein Ende bzw. ein erster Leiterende und ein zweites Leiterende aufweist.

Ein Shunt ist im Allgemeinen ein elektrischer Widerstand, der gezielt zur Messung von Strömen verwendet wird, indem er eine kleine, messbares Spannung proportional zum durchfließenden Strom erzeugt. Herkömmliche Shunts weisen einen geringen Widerstanden im Milliohm-Bereich auf, um den Stromfluss nicht wesentlich zu beeinflussen. Herkömmliche Shunts sind jedoch nicht für hohe Ströme ausgelegt. Das erfindungsgemäße Gleichstrom-Ladekabel ist jedoch insbesondere für Ströme größer 500 A ausgelegt. Statt eines separaten Shunts als Bauelement, nutzt das erfindungsgemäße Gleichstrom-Ladekabel vorzugsweise die erste Leitung neben seiner Hauptfunktion den Gleichstrom zu leiten zusätzlich als Shuntwiderstand bzw. Messwiderstand. Dadurch kann das Gleichstromladekabel mit geringer Komplexität und preisgünstig ausgelegt werden.

Zur Ermittlung des Gleichstroms im Shunt bzw. im ersten Leiter kann das ohmsche Gesetz berechnet werden: ${I}_{Lade} = \frac{{U}_{M 1} - {U}_{L 1}}{{R}_{L}}$ wobei
*I_{Lade}*: *der dem Elektrofahrzeug zugeführte Ladegleichstrom*
*U*_{*M*1}: *die mittels der ersten Messleitung an dem Ende der ersten Leitung gemessene Spannung*
*U*_{*L*1}: *die am Anfang an ersten Leitung anliegende Spannung bzw. Ladesäulenspannung*
*R_{L}*: *momentaner elektrischer Widerstand der ersten Leitung*

Der erste Temperatursensor ist vorzugsweise am Anfang der ersten Leitung angeordnet. Der erste Temperatursensor kann eine Temperatur im Gleichstrom-Ladekabel erfassen. Die erste Leitung umfasst oder besteht vorzugsweise aus Kupfer. Kupfer hat im Allgemeinen einen spezifischen Widerstand zwischen 0,0169 und 0,0175 $\frac{Ω ⋅ {mm}^{2}}{m}$ bei 20°C und einen Temperaturkoeffizienten von ca. 3,93 • 10⁻³ K⁻¹.

Beim Laden eines Elektrofahrzeugs kann sich die erste Leitung auf bis zu T = 90°C erhitzen. Der spezifische Widerstand der ersten Leitung, sofern sie aus Kupfer besteht, wäre dann näherungsweise: $ρ \left(T\right) = ρ \left({T}_{0}\right) ⋅ \left(1+α⋅\left(T-{T}_{0}\right)\right)$ wobei
*ρ*: *spezifischer Widerstand der ersten Leitung bei einer Temperatur T*
*ρ*(*T*₀): *spezifischer Widerstand der ersten Leitung bei T*₀ *= 20°C*
*α*: *Temperaturkoeffizient* d.h. $ρ \left(T\right) = 0 , 0175 \frac{Ω ⋅ {mm}^{2}}{m} ⋅ \left(1+3,93⋅{10}^{- 3}{K}^{- 1}\left(363,15K-293,15K\right)\right)$ $ρ \left(T\right) = 0 , 02231 \frac{Ω ⋅ {mm}^{2}}{m}$

Der spezifische Widerstand einer Kupferleitung erhöht sich also im Wesentlichen um 27%, wenn die Kupferleitung eine Temperatur von 90°C aufweist. Da der elektrische Widerstand der ersten Leitung sich im Wesentlichen gemäß: $R = ρ ⋅ \frac{l}{A}$ Bestimmt, wobei
*R*: *der elektrische Widerstand der ersten Leitung*
*ρ*: *der spezifische Widerstand der ersten Leitung*
*l*: *die Länge der ersten Leitung*
*A: Querschnittsfläche der ersten Leitung*

Ist der elektrische Widerstand im Allgemeinen direkt proportional zum spezifischen Widerstand. Die Länge des Gleichstromladekabels beträgt vorzugsweise 5 m und kann zwischen 3 und 8 m liegen. Ein Querschnittsfläche der ersten Leitung beträgt vorzugsweise 100 mm² und kann zwischen 70 und 150 mm² liegen. Der elektrische Widerstand der ersten Leitung beträgt bei 20°C im Wesentlichen 0,875 mΩ. Bei 90°C beträgt der elektrische Widerstand der ersten Leitung im Wesentlichen 1,112 mΩ. Im Allgemeinen hängt der momentane Widerstand der elektrischen Leitung von der Temperatur der elektrischen Leitung ab.

Herkömmliche Ladevorrichtungen zielen häufig darauf ab etwaige Leitungsverluste im Gleichstrom-Ladekabel lediglich zu kompensieren. Eine weitere bekannte Lösung zielt darauf, die an den Energiespeicher eines Elektrofahrzeugs übertragenen Ladeenergie zu berechnen. Für eine präzise Ermittlung der Ladeleistung und Ladeenergie kommt es jedoch im Allgemeinen nicht darauf an, welche Ladeenergie in Energiespeicher eines Elektrofahrzeugs gelangt. Da das Elektrofahrzeug während eines Ladevorgangs auch Energie verbrauchen könnte, etwa durch eine Klimaanlage oder Heizung, könnte die Ladeenergie im Energiespeicher verfälscht sein. Für eine präzise Ermittlung der Ladeleistung und Ladeenergie ist vorzugsweise eine genaue Messung des Ladestroms und der anliegenden Ladespannung an einem Ladepunkt erheblich.

In einer weiteren Ausgestaltung kann das Gleichstrom-Ladekabel eine erste Messleitung umfassten, die vorzugsweise an einem Ende der ersten Leitung mit der ersten Leitung elektrisch verbunden. Die erste Messleitung kann Kupfer umfassen. Die erste Messleitung ist in etwas so lange wie das Gleichstrom-Ladekabel, insbesondere weist die erste Messleitung 70 - 120% der Länge der ersten Leitung auf. Die erste Messleitung dient vorzugsweise dazu eine Spannung. Die erste Messleitung ist vorzugsweise eine elektrische Verbindung zu einem Spannungsmesspunkt entlang der ersten Leitung. Alternativ zur ersten Messleitung kann ein Funkmessmodul verwendet werden.

Der erste Temperatursensor, die erste Leitung und die erste Messleitung sind vorzugsweise fest im Außenmantel des Gleichstrom-Ladekabels vergossen angeordnet. Dadurch kann das Gleichstrom-Ladekabel insbesondere manipulationssicher ausgelegt werden. Das Gleichstrom-Ladekabel ist durch seine erfindungsgemäße Auslegung geeignet, um präzise Temperatur-, Widerstands-, Strom-, Leistungs- und Energiemessungen bzw. -ermittlungen zu ermöglichen.

In einer weiteren Ausgestaltung kann das Gleichstrom-Ladekable eine Kühlleitung mit Kühlfluid umfassen, die eine Entwärmung der ersten Leitung bewirkt. Der erste Temperatursensor kann an oder in der Kühlleitung angeordnet sein.

Gemäß einer Weiterbildung kann das Gleichstrom-Ladekabel eine zweite Leitung, die Gleichstrom führt, und eine zweite Messleitung, die an einem Ende der zweiten Leitung mit der zweiten Leitung elektrisch verbunden ist, umfassen, wobei eine elektrische Spannung gemessen zwischen der ersten Messleitung und der zweiten Messleitung eine am Elektrofahrzeug anliegende Ladespannung bilden kann, also ${U}_{Lade} = {U}_{M 1} - {U}_{M 2}$ wobei
*U_{Lade}*: *am Elektrofahrzeug anliegende Spannung*
*U*_{*M*1}: *die mittels der ersten Messleitung an dem Ende der ersten Leitung gemessene Spannung*
*U*_{*M*2}: *die mittels der zweiten Messleitung an dem Ende der zweite Leitung gemessene Spannung*

Die zweite Hauptstromleiter kann die zweite Leitung bilden. Die erste und zweite Leitung und die erste und zweite Messleitung können zusammen eine Vier-Leiter-Messvorrichtung bilden. Der erste Temperatursensor, die erste und zweite Leitung und die erste und zweite Messleitung sind vorzugsweise fest im Außenmantel des Gleichstrom-Ladekabels vergossen angeordnet.

Die an das Elektrofahrzeug gelieferte Ladeleistung *P_{Lade}* beträgt vorzugsweise: ${P}_{Lade} = {U}_{Lade} ⋅ {I}_{Lade}$

Die an das Elektrofahrzeug über eine Ladezeit abgegebene Ladeenergie *E_{Lade}* lässt sich insbesondere ermitteln durch das Integral über eine Ladezeit von *t*₁ bis *t*₂: ${E}_{Lade} = {\int }_{{t}_{1}}^{{t}_{2}} {P}_{Lade} dt$

Das Gleichstrom-Ladekabel ist durch seine erfindungsgemäße Auslegung geeignet, um präzise Temperatur-, Widerstands-, Strom-, Leistungs- und Energiemessungen bzw. - ermittlungen zu ermöglichen.

Gemäß einer weiteren Ausgestaltung kann die erste Leitung an einem Anfang einen Ladestations-Spannungsmesspunkt umfasst, wobei ein Quotient aus einem Spannungsabfall über dem Shuntwiderstand und des momentanen elektrischen Widerstands der ersten Leitung einen Ladestrom bildet. Dabei kann das ohmsche Gesetz berechnet werden: ${I}_{Lade} = \frac{{U}_{M 1} - {U}_{L 1}}{{R}_{L}}$ wobei
*I_{Lade}*: *der dem Elektrofahrzeug zugeführte Ladegleichstrom*
*U*_{*M*1}: *die mittels der ersten Messleitung an dem Ende der ersten Leitung gemessene Spannung*
*U*_{*L*1}: *die am Anfang an ersten Leitung anliegende Spannung bzw. Ladesäulenspannung*
*R_{L}*: *momentaner elektrischer Widerstand der ersten Leitung*

Das Gleichstrom-Ladekabel ist durch seine erfindungsgemäße Auslegung geeignet, um präzise Temperatur-, Widerstands-, Strom-, Leistungs- und Energiemessungen bzw. - ermittlungen zu ermöglichen.

In einer weiteren Ausführung kann das Gleichstrom-Ladekabel einen zweiten Temperatursensor umfassen, der am Ende der ersten Leitung angeordnet ist, und wobei der ersten Temperatursensor vorzugsweise am Anfang der ersten Leitung angeordnet ist, um eine Wärmeaufnahme des Kühlfluids zu ermitteln. Noch bevorzugter umfasst das Gleichstrom-Ladekable vier Temperatursensoren, wobei ein dritter Temperatursensor am Anfang der zweiten Leitung angeordnet ist und wobei ein vierter Temperatursensor am Ende der zweiten Leitung angeordnet ist. Mehrere Temperatursensoren ermöglichen insbesondere eine genauere Temperaturmessung am ersten und zweiten Leiter und damit eine höhere Messgenauigkeit. Das Gleichstrom-Ladekabel ist durch seine erfindungsgemäße Auslegung geeignet, um präzise Temperatur-, Widerstands-, Strom-, Leistungs- und Energiemessungen bzw. -ermittlungen zu ermöglichen.

In einer weiteren Ausgestaltung kann das Gleichstrom-Ladekabel wenigstens zwei Daten- und/oder Niederspannungsleitungen und eine Messelektronik umfassen, wobei die zwei Daten- und/oder Niederspannungsleitungen die Messelektronik mit Energie versorgen können. Die Pilot- und Kommunikationsleitungen können die zwei Daten- und/oder Niederspannungsleitungen umfassen.

Die Messelektronik kann vorzugsweise eingesetzt werden, um die vorstehenden Messwerte zu erfassen, die vorstehenden Formeln zu berechnen, Mess- und Rechenergebnisse zu speichern, sowie Grundeinstellungen und -werte zu speichern. Das Gleichstrom-Ladekabel ist durch seine erfindungsgemäße Auslegung geeignet, um präzise Temperatur-, Widerstands-, Strom-, Leistungs- und Energiemessungen bzw. -ermittlungen zu ermöglichen.

Gemäß einer Weiterbildung kann die Messelektronik einen Rechner umfassen, der insbesondere ausgelegt ist eine Ladeleistung und/oder eine Ladeenergie basierend auf dem momentanen elektrischen Widerstand des Shuntwiderstands zu ermitteln. Die Messelektronik kann eine Anzeige zum Anzeigen der Ladeenergie umfassen. Das erfindungsgemäße Gleichstrom-Ladekabel kann einen Ladestecker umfasst, wobei die Messelektronik am oder im Ladestecker angeordnet ist. Alternativ kann die Messelektronik in der Ladesäule angeordnet sein. In einer weiteren Alternative kann die Messelektronik in einem vom Stecker abgesetzt angeordneten Gehäuse am Gleichstrom-Ladekabel angeordnet sein. Das Gehäuse kann zusammen mit dem Kabel vergossen werden und damit manipulationssicher ausgelegt sein. Vorzugsweise kann das Gleichstromladekabel als Ersatz- oder Nachrüst-Teil an Gleichstrom-Ladesäulen angeordnet werden. Das Gleichstrom-Ladekabel ist durch seine erfindungsgemäße Auslegung geeignet, um präzise Temperatur-, Widerstands-, Strom-, Leistungs- und Energiemessungen bzw. -ermittlungen zu ermöglichen.

Ferner wird ein Gleichstromladesystem vorgeschlagen, das insbesondere ein Gleichspannungs-Verteilnetz mit einer ersten Gleichspannung; wenigstens eine Ladesäule, die am Gleichstrom-Verteilnetz angeschlossen ist, wobei die Ladesäule einen Gleichspannungswandler umfasst, der die erste Gleichspannung in eine zweite Gleichspannung wandelt, die niedriger als die erste Gleichspannung ist, und das erfindungsgemäße Gleichstrom-Ladekabel umfasst. Das Gleichstrom-Verteilnetz kann einen Gleichstrom-Bus umfassen, an dem eine hohe Gleichspannung anliegt. Das Gleichstromladesystem kann zwei oder mehr Ladesäulen, eine Photovoltaikanlagen, einen Akkumulator, Gleichrichter und/oder einen Transformator umfassen.

Es wird außerdem ein Messverfahren zur Messung der von einer Ladevorrichtung an ein Elektrofahrzeug abgegebenen elektrischer Energie vorgeschlagen. Das erfindungsgemäße Messverfahren umfassend vorzugsweise die Schritte:
Messen einer Temperatur einer Ladeleitung;
Ermitteln eines momentanen elektrischen Widerstands der Ladeleitung basierend auf einem spezifischen Widerstand der Ladeleitung, einem Temperaturkoeffizienten der Ladeleitung und der Temperatur der Ladeleitung;
Ermitteln eines Spannungsabfalls über eine Länge der Ladeleitung durch Messpunkte am Anfang und am Ende der Ladeleitung, wobei die Ladeleitung als Shunt wirkt;
Ermitteln eines Ladestroms durch einen Quotienten aus Spannungsabfall und momentanen elektrischen Widerstand;
Ermitteln einer momentan abgegebenen Leistung basierend auf dem Ladestrom;
Ermitteln der abgegebenen elektrischen Energie durch Integrieren der momentan abgegebenen Leistung über eine Ladezeit.

In einer erfindungsgemäßen Verwendung kann ein bzw. das erfindungsgemäße Gleichstrom-Ladekabel als Shunt zur Ermittlung der von einer Ladevorrichtung an ein Elektrofahrzeug abgegebenen elektrischen Energie, insbesondere gemäß des erfindungsgemäßen Messverfahrens, verwendet werden.

### KURZBESCHREIBUNG DER ZEICHNUNGEN

Ausführungsbeispiele der Erfindung werden anhand der Zeichnungen und der nachfolgenden Beschreibung näher erläutert. Es zeigen:
Figur 1 ein Ausführungsbeispiel eines Gleichstrom-Ladekabels gemäß der Erfindung,
Figur 2 ein Ausführungsbeispiel für ein Gleichstromladesystem gemäß der Erfindung und
Figur 3 ein Ausführungsbeispiel für ein Messverfahren gemäß der Erfindung.

### AUSFÜHRUNGSFORMEN DER ERFINDUNG

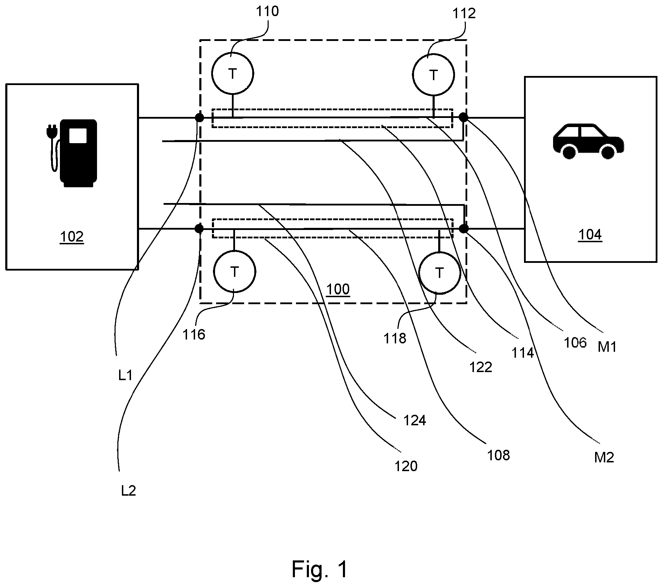

In der Figur 1 ist ein Gleichspannungs-Ladekabel 100 gezeigt. Das Gleichspannungs-Ladekabel 100 ist zwischen einer Gleichspannungsladesäule 102 und einem zu ladenden Elektrofahrzeug 104 angeordnet und verbindet das Elektrofahrzeug 104 elektrisch mit der Gleichspannungsladesäule 102. Das Gleichspannungs-Ladekabel 100 umfasst eine erste Hauptstromleitung 106 und eine zweite Hauptstromleitung 108. Die Hauptstromleitung 106 und/oder die Hauptstromleitung 108 bilden einen Shuntwiderstand. Am ersten Ende der Hauptstromleitung 106 ist ein erster Temperatursensor 110 angeordnet. Am zweiten Ende der Hauptstromleitung 106 ist ein zweiter Temperatursensor 112 angeordnet. Die Hauptstromleitung 106 ist von einer Kühlleitung 114 umgeben, in der ein Kühlfluid zirkuliert.

Am ersten Ende der Hauptstromleitung 108 ist ein dritter Temperatursensor 116 angeordnet. Am zweiten Ende der Hauptstromleitung 108 ist ein vierter Temperatursensor 118 angeordnet. Die Hauptstromleitung 108 ist von einer weiteren Kühlleitung 120 umgeben, in der ein Kühlfluid zirkuliert.

Die Hauptstromleitung 106 weist am ersten Ende einen ersten Spannungsmesspunkt L1 und am zweiten Ende einen Spannungsmesspunkt M1 auf, wobei der Spannungsmesspunkt M1 mit einer ersten Messleitung 122 verbunden ist, die eine Spannungsmesswert-Erfassung an einem abgesetzten Ort bzw. in der Nähe des ersten Endes der Hauptstromleitung 106 ermöglicht.

Die Hauptstromleitung 108 weist am ersten Ende einen ersten Spannungsmesspunkt L2 und am zweiten Ende einen Spannungsmesspunkt M2 auf, wobei der Spannungsmesspunkt M2 mit einer zweiten Messleitung 124 verbunden ist, die eine Spannungsmesswert-Erfassung an einem abgesetzten Ort bzw. in der Nähe des ersten Endes der Hauptstromleitung 108 ermöglicht.

Die Hauptstromleitung 106 besteht aus Kupfer, ist 5 m lang, hat eine Querschnittsfläche von 100 mm² und ist ausgelegt einen Strom von 1000 A zu leiten. Der spezifische Widerstand des Kupfers beträgt 0,0175 $\frac{Ω ⋅ {mm}^{2}}{m}$ bei 20°C und der Temperaturkoeffizienten des Kupfers beträgt ca. 3,93 • 10⁻³ K⁻¹. Der Hauptstromleiter 106 hat einen Widerstand von 0,875 mΩ. Die Verlustleistung *P_{V}* im Hauptstromleiter 106 beträgt nach *P_{V} = R · I*² = *875 W.* Der Hauptstromleiter 106 erwärmt sich. Die Kühlleitung 114 kühlt den Hauptstromleiter 106 auf konstant 90°C. Bei 90°C hat der Hauptstromleiter 106 einen Widerstand von 1,112 mΩ. Die Ladesäule stellt am Spannungsmesspunkt L1 eine Spannung bereit. Über dem Hauptstromleiter 106 fällt diese Spannung auf eine Spannung *U*_{*M*1} ab. Der Ladestrom beträgt ${I}_{Lade} = \frac{{U}_{M 1} - {U}_{L 1}}{{R}_{L}}$ wobei
*I_{Lade}*: *der dem Elektrofahrzeug zugeführte Ladegleichstrom*
*U*_{*M*1}: *die mittels der ersten Messleitung an dem Ende der ersten Leitung gemessene Spannung*
*U*_{*L*1}: *die am Anfang an ersten Leitung anliegende Spannung bzw. Ladesäulenspannung*
*R_{L}*: *momentaner elektrischer Widerstand der ersten Leitung*

Mithilfe der zweiten Messleitung kann die Spannung *U*_{*M*2} gemessen werden, mit deren Hilfe sich die Ladespannung ergibt zu: ${U}_{Lade} = {U}_{M 1} - {U}_{M 2}$ wobei
*U_{Lade}*: *am Elektrofahrzeug anliegende Spannung*
*U*_{*M*1}: *die mittels der ersten Messleitung an dem Ende der ersten Leitung gemessene Spannung*
*U*_{*M*2}: *die mittels der zweiten Messleitung an dem Ende der zweite Leitung gemessene Spannung*

Die an das Elektrofahrzeug gelieferte Ladeleistung *P_{Lade}* beträgt vorzugsweise: ${P}_{Lade} = {U}_{Lade} ⋅ {I}_{Lade}$

Die an das Elektrofahrzeug über eine Ladezeit abgegebene Ladeenergie *E_{Lade}* lässt sich insbesondere ermitteln durch das Integral über eine Ladezeit von *t*₁ bis *t*₂: ${E}_{Lade} = {\int }_{{t}_{1}}^{{t}_{2}} {P}_{Lade} dt$

Das Gleichstrom-Ladekabel ermöglicht durch seinen Aufbau eine präzise Temperatur-, Widerstands-, Strom-, Leistungs- und Energiemessungen bzw. -ermittlung.

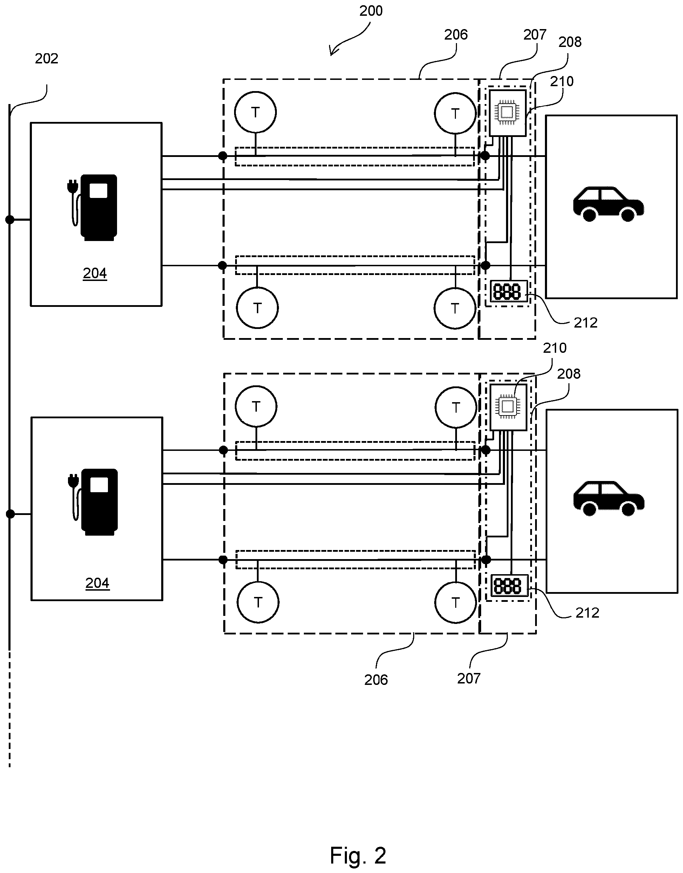

In der Figur 2 ist ein Gleichstromladesystem 200 gezeigt. Das Gleichstromladesystem 200 umfasst einen DC-Bus bzw. eine Gleichspannungs-Leitung 202 sowie mehrere daran elektrisch angeschlossene Ladesäulen 204. Die Ladesäulen 204 weisen jeweils einen DC-/DC-Wandler auf, um die Spannung des DC-Busses auf eine niedrigere Gleichspannung zu wandeln. Ferner weist jede Ladesäule 204 ein Ladekabel 206 auf. Die Ladekabel 206 umfassen die zwei Hauptstromleitungen, Temperatursensoren, Kühlleitungen, Spanungsmesspunkte und Messleitungen des Ausführungsbeispiels in Figur 1. Ferner umfassen die Ladekabel 206 je einen Ladestecker 207. Der Ladestecker 207 umfasst eine Messelektronik 208. Die Messelektronik 208 umfasst einen Rechner 210 und ein Display 212. Die Messelektronik 208 ist mit der Ladesäule 204, mit den Messpunkten L1, L2, M1, M2 und mit den Temperatursensoren verbunden, um präzise Temperatur-, Widerstands-, Strom-, Leistungs- und Energiemessungen bzw. -ermittlungen zu ermöglichen. Das Display ist ausgelegt die einem Elektrofahrzeug bereitgestellt Ladeenergie anzuzeigen. Ferner ist das Display ausgelegt die gesamte Ladeenergie anzuzeigen, die seit einer Initialisierung oder einem Neustart abgegeben wurde.

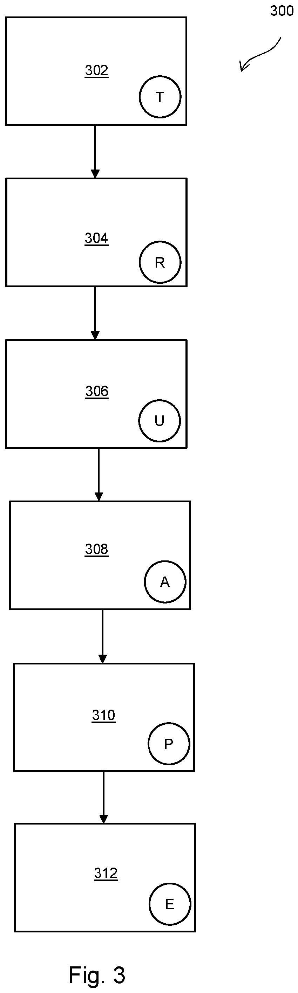

In der Figur 3 ein Messverfahren 300 zur Messung der von einer Ladevorrichtung an ein Elektrofahrzeug abgegebenen elektrischer Energie gezeigt. Das Messverfahren 300 umfassend die Schritte: Messen einer Temperatur einer Ladeleitung 302; Ermitteln eines momentanen elektrischen Widerstands der Ladeleitung 304 basierend auf einem spezifischen Widerstand der Ladeleitung, einem Temperaturkoeffizienten der Ladeleitung und der Temperatur der Ladeleitung; Ermitteln eines Spannungsabfalls über eine Länge der Ladeleitung durch Messpunkte am Anfang und am Ende der Ladeleitung 306, wobei die Ladeleitung als Shunt wirkt; Ermitteln eines Ladestroms mittels eines Quotienten aus Spannungsabfall und momentanen elektrischen Widerstand 308; Ermitteln einer momentan abgegebenen Leistung bzw. Ladeleistung basierend auf dem Ladestrom 310 und Ermitteln der abgegebenen elektrischen Energie durch Integrieren der momentan abgegebenen Leistung über eine Ladezeit 312.

### BEZUGSZEICHENLISTE

- 100: Ladekabel
- 102: Gleichspannungsladesäule
- 104: Elektrofahrzeug
- 106: Hauptstromleitung
- 108: Hauptstromleitung
- 110: erster Temperatursensor
- 112: zweiter Temperatursensor
- 114: Kühlleitung
- 116: dritter Temperatursensor
- 118: vierter Temperatursensor
- 120: Kühlleitung
- 122: erste Messleitung
- 124: zweite Messleitung
- M1: Spannungsmesspunkt
- L1: Spannungsmesspunkt
- M2: Spannungsmesspunkt
- L2: Spannungsmesspunkt
- 200: Gleichspannungsladesystem
- 202: Gleichspannungs-Leitung
- 204: Ladesäule
- 206: Ladekabel
- 207: Ladestecker
- 208: Messelektronik
- 210: Rechner
- 212: Display
- 300: Messverfahren
- 302 - 312: Verfahrensschritte

## Patentansprüche

1. Gleichstrom-Ladekabel (100; 206), insbesondere zum Laden eines Elektrofahrzeugs (104), mit
wenigstens einer ersten Leitung (106, 108), die dem Elektrofahrzeug (104) Gleichstrom zuführt, wobei die erste Leitung (106, 108) einen Shuntwiderstand zur Ermittlung des Gleichstroms bildet, und
einem ersten Temperatursensor (110), der entlang der ersten Leitung (106, 108) angeordnet ist
**dadurch gekennzeichnet, dass**
wobei ein momentaner elektrischer Widerstand des Shuntwiderstands von einer mittels des ersten Temperatursensors (110) ermittelten Temperatur abhängt.

2. Gleichstrom-Ladekabel (100; 206), nach Anspruch 1
**dadurch gekennzeichnet, dass**
das Gleichstrom-Ladekabel (100; 206)
eine ersten Messleitung (122, 124) umfasst, die an einem Ende der ersten Leitung (106, 108) mit der ersten Leitung (106, 108) elektrisch verbunden ist.

3. Gleichstrom-Ladekabel (100; 206) nach Anspruch 1 oder 2
**dadurch gekennzeichnet, dass**
das Gleichstrom-Ladekabel (100; 206) eine Kühlleitung (114, 120) mit Kühlfluid umfasst, die eine Entwärmung der ersten Leitung (106, 108) bewirkt:

4. Gleichstrom-Ladekabel (100; 206) nach Anspruch 3
**dadurch gekennzeichnet, dass**
das Gleichstrom-Ladekabel (100; 206)
eine zweite Leitung (108), die Gleichstrom führt, und
eine zweite Messleitung (124), die an einem Ende der zweiten Leitung (108) mit der zweiten Leitung (108) elektrisch verbunden ist, umfasst, wobei eine elektrische Spannung gemessen zwischen der ersten Messleitung (122) und der zweiten Messleitung (124) eine am Elektrofahrzeug (104) anliegende Ladespannung bildet.

5. Gleichstrom-Ladekabel (100; 206) nach einem der vorhergehenden Ansprüche
**dadurch gekennzeichnet, dass**
die erste Leitung (106, 108) an einem Anfang einen Ladestations-Spannungsmesspunkt (M1) umfasst, wobei ein Quotient aus einem Spannungsabfall über dem Shuntwiderstand und des momentanen elektrischen Widerstands der ersten Leitung (106, 108) einen Ladestrom bildet.

6. Gleichstrom-Ladekabel (100; 206) nach einem der vorhergehenden Ansprüche **dadurch gekennzeichnet, dass**
das Gleichstrom-Ladekabel (100; 206) einen zweiten Temperatursensor (112) umfasst, der am Ende der ersten Leitung (106, 108) angeordnet ist, und wobei der ersten Temperatursensor (110) am Anfang der ersten Leitung angeordnet ist, um eine Wärmeaufnahme des Kühlfluids zu ermitteln.

7. Gleichstrom-Ladekabel (100; 206) nach einem der vorhergehenden Ansprüche **dadurch gekennzeichnet, dass**
das Gleichstrom-Ladekabel (100; 206)
wenigstens zwei Daten- und/oder Niederspannungsleitungen und
eine Messelektronik (208) umfasst, wobei die zwei Daten- und/oder Niederspannungsleitungen die Messelektronik (208) mit Energie versorgen.

8. Gleichstrom-Ladekabel (100; 206) nach Anspruch 7
**dadurch gekennzeichnet, dass**
die Messelektronik (208) einen Rechner (210) umfasst, der ausgelegt ist eine Ladeleistung und/oder eine Ladeenergie basierend auf dem momentanen elektrischen Widerstand des Shuntwiderstands zu ermitteln.

9. Gleichstrom-Ladekabel (100; 206) nach Anspruch 7 oder 8
**dadurch gekennzeichnet, dass**
die Messelektronik (208) eine Anzeige (212) zum Anzeigen der Ladeenergie umfasst.

10. Gleichstrom-Ladekabel (100; 206) nach einem der Ansprüche 7 bis 9
**dadurch gekennzeichnet, dass**
das Gleichstrom-Ladekabel (100; 206) einen Ladestecker (207) umfasst, wobei die Messelektronik (208) am oder im Ladestecker (207) angeordnet ist.

11. Gleichstromladesystem (200) umfassend
ein Gleichspannungs-Verteilnetz (202) mit einer ersten Gleichspannung; wenigstens eine Ladesäule (204), die am Gleichstrom-Verteilnetz (202) angeschlossen ist, wobei die Ladesäule (204) einen Gleichspannungswandler umfasst, der die erste Gleichspannung in eine zweite Gleichspannung wandelt, die niedriger als die erste Gleichspannung ist; und
ein Gleichstrom-Ladekabel (100; 206) nach einem der vorhergehenden Ansprüche.

12. Messverfahren (300) zur Messung der von einer Ladevorrichtung an ein Elektrofahrzeug abgegebenen elektrischer Energie, umfassend die Schritte:
Messen einer Temperatur einer Ladeleitung (302);
Ermitteln eines momentanen elektrischen Widerstands der Ladeleitung (304) basierend auf einem spezifischen Widerstand der Ladeleitung, einem Temperaturkoeffizienten der Ladeleitung und der Temperatur der Ladeleitung;
Ermitteln eines Spannungsabfalls über eine Länge der Ladeleitung (306) durch Messpunkte am Anfang und am Ende der Ladeleitung, wobei die Ladeleitung als Shunt wirkt;
Ermitteln eines Ladestroms (308) durch einen Quotienten aus Spannungsabfall und momentanen elektrischen Widerstand;
Ermitteln einer momentan abgegebenen Leistung (310) basierend auf dem Ladestrom;
Ermitteln der abgegebenen elektrischen Energie (312) durch Integrieren der momentan abgegebenen Leistung über eine Ladezeit.

13. Verwendung eines Gleichstrom-Ladekabels, insbesondere gemäß einem der Ansprüche 1 bis 10, als Shunt zur Ermittlung der von einer Ladevorrichtung an ein Elektrofahrzeug abgegebenen elektrischen Energie, insbesondere gemäß dem Messverfahren in Anspruch 12.
